(19) Europäisches Patentamt
European Patent Office
Office européen des brevets

(11) **EP 2 204 847 A1**

(12) **EUROPEAN PATENT APPLICATION**
published in accordance with Art. 153(4) EPC

(43) Date of publication:
**07.07.2010 Bulletin 2010/27**

(51) Int Cl.:
***H01L 21/66*** *(2006.01)*

(21) Application number: **08840886.9**

(22) Date of filing: **03.10.2008**

(86) International application number:
**PCT/JP2008/068012**

(87) International publication number:
**WO 2009/054250 (30.04.2009 Gazette 2009/18)**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **24.10.2007 JP 2007276309**
**21.08.2008 JP 2008212724**

(71) Applicant: **Sumitomo Electric Industries, Ltd.**
**Chuo-ku**
**Osaka-shi**
**Osaka 541-0041 (JP)**

(72) Inventors:
• **SHIBATA, Kaoru**
**Itami-shi**
**Hyogo 664-0016 (JP)**

• **OKABAYASHI, Shinji**
**Itami-shi**
**Hyogo 664-0016 (JP)**
• **HONZU, Yasuhiro**
**Itami-shi**
**Hyogo 664-0016 (JP)**
• **IRIKURA, Masato**
**Itami-shi**
**Hyogo 664-0016 (JP)**
• **NAKANISHI, Fumitake**
**Itami-shi**
**Hyogo 664-0016 (JP)**

(74) Representative: **Grünecker, Kinkeldey,**
**Stockmair & Schwanhäusser**
**Anwaltssozietät**
**Leopoldstrasse 4**
**80802 München (DE)**

(54) **SEMICONDUCTOR SUBSTRATE AND METHOD FOR INSPECTING SEMICONDUCTOR SUBSTRATE**

(57)     Affords semiconductor wafers that achieve uniformization of semiconductor films.

In a semiconductor wafer (1), between one and twenty pinholes (3) are formed per wafer for two-inch diameter semiconductor wafers (1). An effect whereby the warp in the semiconductor wafer (1) following semiconductor film formation is reduced, and dimensional variation following photolithographic exposure is reduced can thereby be obtained. This is presumed to be because dislocations in the semiconductor wafer (1) front side are extinguished by the presence of the pinholes (3). Accordingly, this can serve to make the quality of semiconductor films consistent, make the performance of semiconductor devices consistent, and prevent fracture of the semiconductor wafer (1).

FIG. 1

**Description**

Technical Field

This invention relates to semiconductor wafers and to methods of inspecting semiconductor wafers; the invention relates in particular to semiconductor wafers in which micropipes/pinhole defects (termed pinholes hereinafter) appear, and to methods of inspecting such semiconductor wafers.

Background Art

In the manufacture of semiconductor devices such as optoelectronic device elements and electronic devices, generally a variety of chemical and physical processes are executed on the front side of a semiconductor wafer-processes, for example, involving the formation of epitaxial films onto the wafer front side. Ordinarily, the existence of defects such as pinholes in the front side of a semiconductor wafer is regarded as hindering the formation of uniform semiconductor films onto the semiconductor wafer front side, such that inspecting for the presence of pinholes is seen as crucial. For this reason, to date various methods of inspecting semiconductor wafers for pinholes have been proposed. (For example, reference is made to Patent Document 1.)

In Patent Document 1 a method is disclosed whereby a semiconductor wafer in which pinholes appear is immersed in molten potassium hydroxide (KOH) to chemically etch the micropipes, and an instrument of observation such as a light microscope is employed to detect micropipes and other macro-defects in the crystal.

*Patent Document 1*: Japanese Unexamined Pat. App. Pub. No. 10-509943.

Disclosure of Invention

*Problem Invention Is to Solve*

The present inventors proceeded with investigations into the formation of uniform semiconductor films onto the front side of a semiconductor wafer. As a result, the present inventors, shattering the preconceived notion that in order to make a semiconductor film uniform, it is preferable that pinholes not be present in the semiconductor wafer, clarified for the first time the possibility that the presence of pinholes in a semiconductor wafer allows uniformization of a semiconductor film layered onto the semiconductor wafer to be accomplished.

For that reason, a principal object of this invention is to make available semiconductor wafers that by the presence of pinholes in the semiconductor wafers achieve uniformization of semiconductor films. And another object of the invention is to make available a semiconductor wafer inspection method that allows location and number of pinholes in a semiconductor wafer to be efficiently examined.

*Means for Resolving the Problem*

The present inventors investigated the reasons why the presence of pinholes in a semiconductor wafer can accomplish uniformization of a semiconductor film. Inferring as a result that dislocations in the wafer front side are extinguished by the formation of a predetermined number and diameter of pinholes, on account of which warpage in the wafer disappears, they rendered the present invention in the following constitutional form.

In a semiconductor wafer involving the invention, between one and twenty pinholes are formed per two inches diameter. In accordance with this constitutional form, the presence of between one and twenty pinholes is presumed to extinguish dislocations in the semiconductor wafer front side. The warp in the wafer following film formation is reduced, and dimensional variation following photolithographic exposure is reduced. If there are no pinholes (the count is 0), then extinction of dislocations does not occur. On the other hand, instances where the number of pinholes is twenty-one or more are thought instead to give rise to strain in the wafer front side, therefore exacerbating the warp in the wafer.

When by vapor-phase deposition, for example, a semiconductor film is deposited via epitaxial growth onto the front side of a semiconductor wafer, making the temperature of the semiconductor wafer front side uniform is crucial. If the warp in the wafer is reduced, the front side temperature of the semiconductor wafer can be made uniform, whereby the composition of the epitaxial layers can be made uniform. Again, if warpage in a semiconductor wafer is large, during heating and semiconductor film formation problems of the wafer cracking or the wafer flying off the susceptor on which it is retained can arise. Provided that the warp in a wafer is small, fracturing of the wafer may be squelched. Accordingly, semiconductor wafers of the invention can serve to make the quality of semiconductor films consistent, make the performance of semiconductor devices consistent, and prevent semiconductor wafer fracture.

In the aforedescribed semiconductor wafer, preferably the diameter of the pinholes is between 0.45 $\mu$m and 5 $\mu$m. In this case, defining the pinhole size makes it possible even further to reduce warp in the semiconductor wafer following semiconductor film formation, and dimensional variation following photolithographic exposure. If the pinhole diameter is less than 0.45 $\mu$m, the effect of extinguishing dislocations is not sufficiently gained. Meanwhile, if the pinhole diameter exceeds 5 $\mu$m, it is thought that in the wafer front side strain instead occurs, owing to which the warp in the wafer is enlarged.

A semiconductor wafer inspection method involving the invention is provided with a step of contacting a chuck stage onto the front side of a wafer to vacuum chuck it, and determining whether pinholes are present in the wafer by either change in the vacuum level with elapsed time, or by whether there is detection of a detecting gas. Additionally provided is a step of directing a beam of light onto the front side of a wafer determined to have pinholes, detecting light rays passing through the wafer, and thereby specifying the number and position of the pinholes.

In a method thus rendered, after the determination as to the presence of pinholes in wafers is made, the examination to specify the number and position of pinholes is carried out on only those wafers determined to have pinholes. An examination for specifying the number and position of pinholes in respect of the total number of wafers is not implemented. That is, wafers in which it is determined that pinholes do not exist are excluded from the examination for specifying the number and position of pinholes. Consequently, wafers can be efficiently inspected for the presence of pinholes, and when pinholes are present, their position and number, can be efficiently examined. What is more, versus the conventional inspection method of immersing semiconductor wafers into a solution to detect defects, the wafers do not come into contact with any solvent; therefore there is no risk of the wafers being contaminated, enabling the inspection to be done with greater ease and convenience.

*Effects of the Invention*

According to a semiconductor wafer of the invention, the existence of pinholes allows uniformization of semiconductor films to be achieved. According to a semiconductor wafer inspection method of the invention, the position and number of pinholes in a semiconductor wafer may be efficiently examined.

Brief Description of Drawings

Fig. 1 is a diagram schematically representing an example of a pinhole appearing in a wafer;
Fig. 2 is a diagram schematically representing another example of a pinhole appearing in a wafer;
Fig. 3 is a diagram illustrating the definition of SORI;
Fig. 4 is a flowchart representing semiconductor wafer inspection method;
Fig. 5 is a diagram schematically representing an example of a device for determining whether pinholes are present;
Fig. 6 is a diagram schematically representing another example of a device for determining whether pinholes are present;
Fig. 7 is a diagram schematically representing the configuration of a chuck unit in which a porous plate is adopted;
Fig. 8 is an oblique view indicating details of the porous plate represented in Fig. 7;
Fig. 9 is a schematic diagram illustrating still another example of a device, employing the chuck unit represented in Fig. 7, for determining whether pinholes are present; and
Fig. 10 is a diagram schematically representing an example of a device for specifying pinhole count and position.

*Legend*

| | |
|---|---|
| 1: | semiconductor wafer |
| 1*a*: | front side |
| 1*b*: | back side |
| 2: | pinhole appearance site |
| 3: | pinhole |
| 5: | reference plane |
| 11: | chuck stage |
| 12, 22: | O-ring |
| 13: | wafer tray |
| 14, 24, 34, 47: | arrows |
| 21: | chamber |
| 23: | detecting-gas supply unit |

| 25: | gas detection device |
| 31: | light source |
| 32: | light ray |
| 40: | chuck unit |
| 41: | porous plate |
| 41*a*: | full-contact surface |
| 42: | gel pad |
| 43: | pedestal |
| 43*a*: | recess |
| 44: | ventilation channel |
| 45: | ventilation duct |
| 46: | exhaust tube |
| 100: | supply line |
| 110: | vacuum pump |
| 120: | pressure gauge |

Best Mode for Carrying Out the Invention

Below, a description of modes of embodying the present invention will be made based on the drawings. It should be understood that in the following identical or corresponding parts in the drawings are labeled with identical reference numbers and their description will not be repeated.

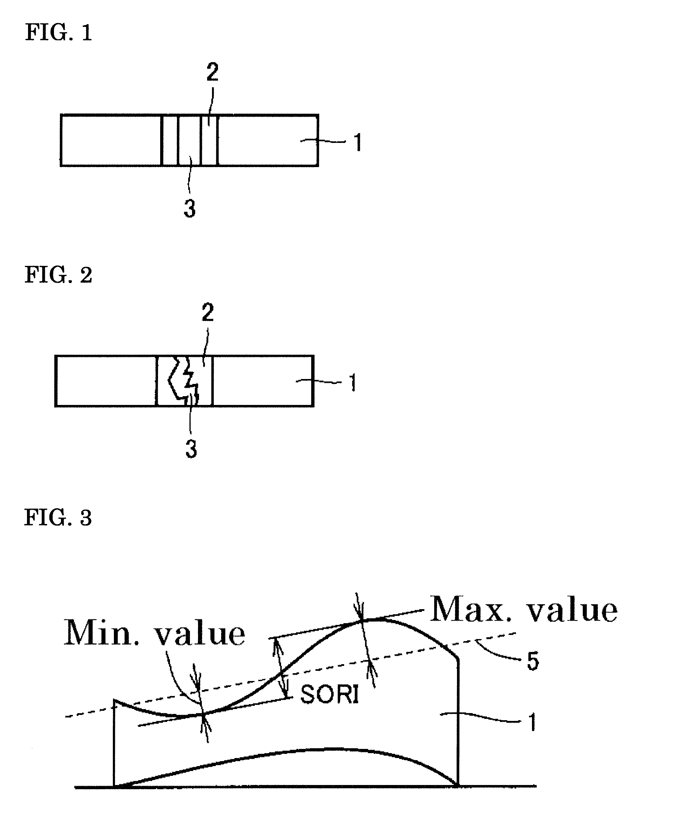

Figs. 1 and 2 are diagrams schematically representing examples of pinholes appearing in a wafer. As indicated in Fig. 1, a pinhole 3 rectilinearly penetrating a semiconductor wafer 1 thickness-wise is formed in a pinhole appearance site 2 in the semiconductor wafer 1. Although not represented in the figure, pinholes diagonally penetrating a semiconductor wafer appear (that is, the pinholes form inclined with respect to the front side of the semiconductor wafer) in some instances. And as indicated in Fig. 2, a zigzag-shaped pinhole 3 sometimes appears. Such pinholes 3 form, for example, due to falling matter inside the furnace when an ingot is produced getting caught in the ingot interior, and when the ingot is sliced to produce semiconductor wafers the trapped fallen matter coming loose or crumbling. In other words, the casts for pinholes form when an ingot is produced by the crystal growth operation, and during ingot slicing and related processes, the pinholes are revealed.

It should be noted that, as for defects that occur on the front side of a semiconductor wafer 1, other than the pinholes 3, depicted in Figs. 1 and 2, penetrating the semiconductor wafer 1 thickness-wise, pits as though the front side had been pecked also can appear. While in general pits in the front side are sometimes termed "pinholes," in the present specification, "pinholes" shall mean micro-holes penetrating a semiconductor wafer through its thickness.

To begin with, the relationship between the per-substrate number of pinholes arising in 2-inch diameter semiconductor wafers, and the warp (in microns) in the semiconductor wafers after a semiconductor film was formed onto the front side of the semiconductor wafers by epitaxial growth as well as the variation (in percentages) in the dimensions of the photolithographic exposure pattern after the wafer was photolithographically exposed was investigated. The results are set forth in Table I.

Table I

| Embod. | Pinhole count (no./2-in wafer) | Post-epi. warp (μm) | Post-photolith.-exposure dimensional variation (±%) |
|---|---|---|---|
| 1-1 | 0 | 12.2 | 24.4 |
| 1-2 | 1 | 8 | 3.3 |
| 1-3 | 2 | 8.2 | 3.2 |
| 1-4 | 4 | 7.8 | 3.4 |
| 1-5 | 5 | 7.7 | 3.0 |
| 1-6 | 10 | 8.1 | 6.8 |
| 1-7 | 17 | 8.5 | 9.9 |
| 1-8 | 20 | 9.1 | 14.3 |

(continued)

| Embod. | Pinhole count (no./2-in wafer) | Post-epi. warp (μm) | Post-photolith.-exposure dimensional variation (±%) |
|---|---|---|---|
| 1-9 | 21 | 11.3 | 25.2 |

As indicated in Table I, in contrast with the instances in which the pinhole count was 0 holes (Embodiment 1-1) and 21 holes (Embodiment 1-9), in the instances in which the pinhole count was between 1 hole and 20 holes (Embodiments 1-2 to 1-8), warp in the semiconductor wafers and dimensional variation in their photolithographic exposure patterns together decreased.

Herein, warp in the semiconductor wafers was assessed according to the value SORI. The numerical value that is the difference between the maximum and minimum values of the data from all probe points on a not-chucked wafer is taken as "SORI." Fig. 3 is a diagram illustrating the definition of the value SORI. As indicated in Fig. 3, in a state in which a wafer 1 in which there is warpage is not chuck-clamped to a flat platen, the difference between the maximum and minimum values of the distance between the front side of the wafer 1, where it does not face onto the platen, and a reference plane 5 is the value WARP. The reference plane 5 is a least-squares plane.

Furthermore, the dimensional variation in photolithographic exposure pattern was assessed according to the precision of a resist pattern in an instance in which the pattern was fabricated with, for example, 10 μm being the target linewidth for the resist, by gauging widths in the pattern actually photolithographed on the wafer front side by photolithographic exposure. The pattern dimensions in nine arbitrary points along the wafer front side were measured, and the dimensional variation (as a percentage) with respect to the maximum value and the minimum value was calculated according to the following formula.

$$\text{Dimensional variation} = (\text{max. value} - \text{min. value}) / (\text{max. value} + \text{min. value}) \times 100 \, (\%)$$

Next, the relationship between the pinhole diameter (in microns) and pinhole position (in mm), and the warp in the semiconductor wafer and dimensional variation in photolithographic exposure pattern, in instances in which one pinhole per 2-inch diameter semiconductor wafer appeared, was investigated. The results are set forth in Table II. Therein, for gauging pinhole position, pinhole positions were given by radial distances with the referent being the circumferential edge of the wafer as the zero point (that is, the point where the pinhole position was 0 mm).

Table II

| Embod. | Pinhole size (μm) | Pinhole pos. (mm) | Post-epi. warp (μm) | Post-photolith.-exposure dimensional variation (±%) |
|---|---|---|---|---|
| 2-1 | 0.07 | 6.2 | 9.7 | 14.2 |
| 2-2 | 0.15 | 4.6 | 8.8 | 5.2 |
| 2-3 | 0.25 | 8 | 8.5 | 4.1 |
| 2-4 | 0.45 | 7.6 | 7.8 | 3.8 |
| 2-5 | 0.6 | - | 7.9 | 2.9 |
| 2-6 | 1.2 | 10 | 7.7 | 3.0 |
| 2-7 | 2 | - | 7.6 | 2.8 |
| 2-8 | 5 | - | 7.8 | 3.1 |
| 2-9 | 50 | - | 8.3 | 3.7 |
| 2-10 | 300 | - | 9.3 | 13.8 |

According to the embodiments set forth in Table II, in instances where the pinhole count was one, in a range in which the diameter of the pinholes is between 0.45 μm and 5 μm, a trend toward decrease in the semiconductor wafer warp and in the dimensional variation in photolithographic exposure pattern can be seen. It will be appreciated that in the range in which the pinhole diameter is 0.45 $\mu$m to 5 $\mu$m, which Embodiments 2-4 to 2-8 exhibit, semiconductor wafer warp and photolithographic-exposure-pattern dimensional variation are within a range tantamount to the values for Embodiment 1-2 set forth in Table I.

Meanwhile, no correlation of pinhole position with the semiconductor wafer warp and the photolithographic-exposure-pattern dimensional variation could be particularly recognized.

As in the above, according to Table I, when between one and twenty pinholes appear per a 2-inch diameter semiconductor wafer, obtainable is an effect whereby the warp in the semiconductor wafer following semiconductor film formation is reduced, and the dimensional variation in the photolithographic exposure pattern is reduced. This phenomenon is presumed to be because dislocations in the front side of the semiconductor wafer are extinguished by the presence of the pinholes. This can serve to uniformize the quality of semiconductor films, uniformize the performance of semiconductor devices, and prevent semiconductor wafer fracture.

And according to Table II, if the diameter of the pinholes is between 0.45 $\mu$m and 5 $\mu$m, defining the pinhole size makes it possible even further to reduce the warp in a semiconductor wafer following semiconductor film formation, and dimensional variation following photolithographic exposure.

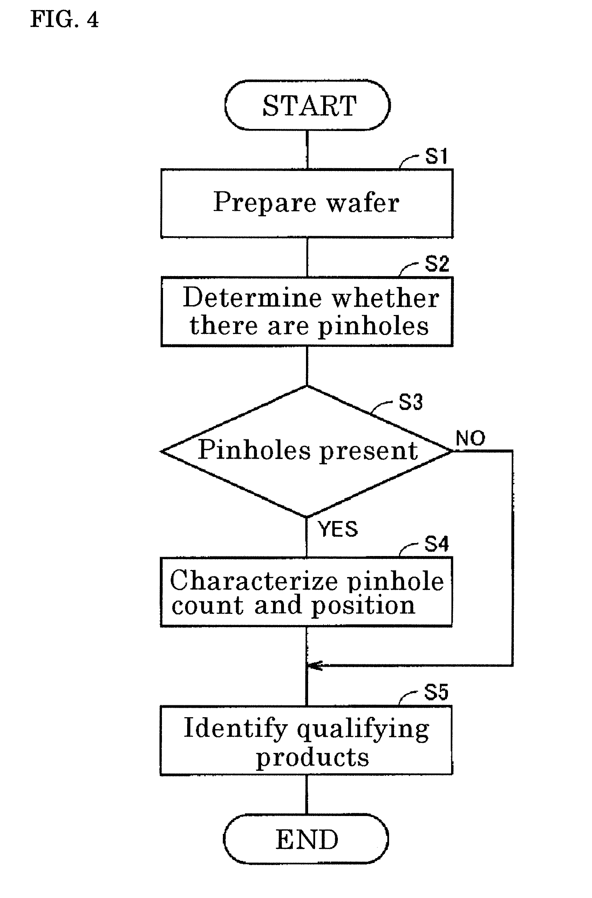

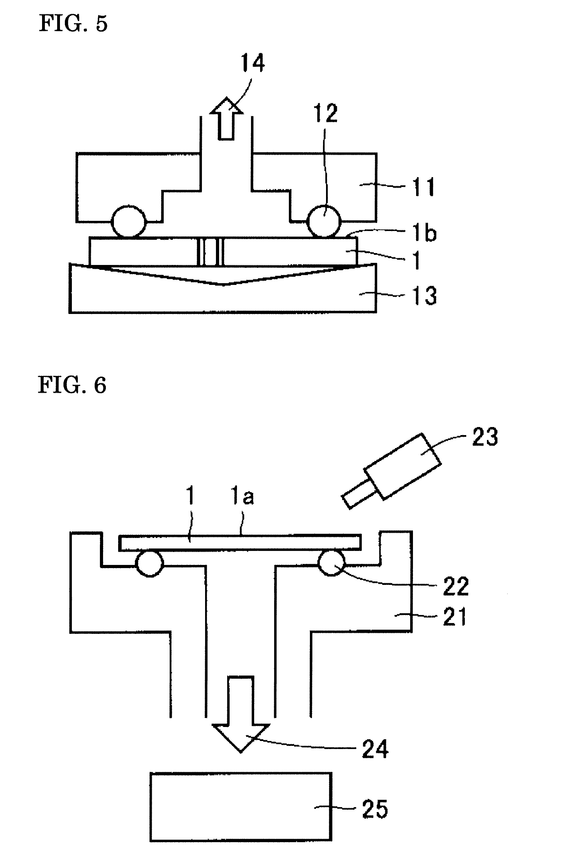

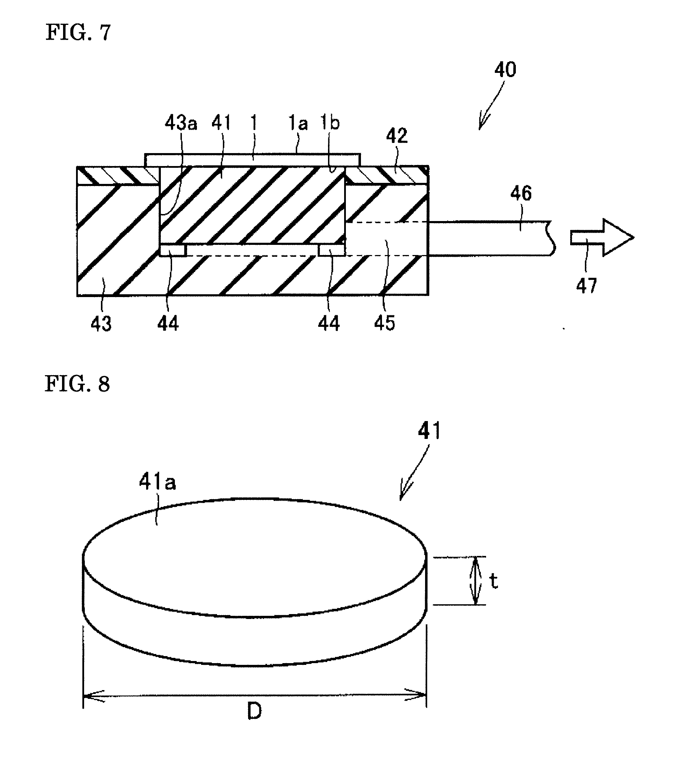

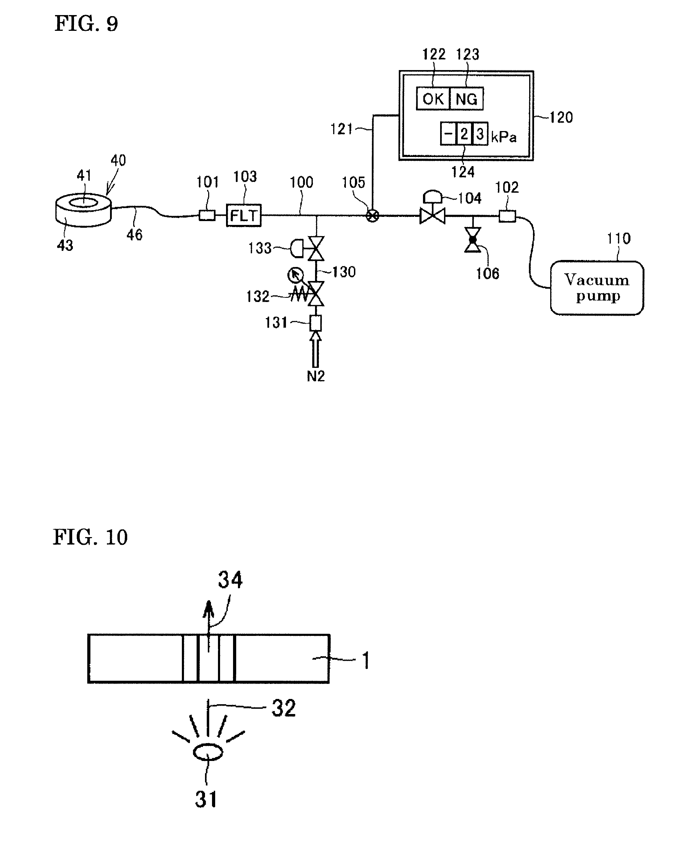

Next, a method of inspecting semiconductor wafers will be described. Fig. 4 is a flowchart representing the semiconductor wafer inspection method. Fig. 5 and Fig. 6 are diagrams schematically representing examples of devices for determining whether pinholes are present. Fig. 7 is a diagram schematically representing the configuration of a chuck unit in which a porous plate is adopted. Fig. 8 is an oblique view indicating details of the porous plate represented in Fig. 7. Fig. 9 is a schematic diagram illustrating still another example of a device, employing the chuck unit represented in Fig. 7, for determining whether pinholes are present. Fig. 10 is a diagram schematically representing an example of a device for specifying pinhole count and position. The description of the semiconductor wafer inspection method will be made referring to Figs. 4 through 10.

As shown in Fig. 4, in Step S1 wafers are prepared. For example, semiconductor wafers can be produced by slicing an ingot grown from a seed crystal, and then can be submitted to the inspection.

Next, in Step S2 whether pinholes are present is determined. The adhesion-modeled inspection device represented in Fig. 5 can for example be employed. In the inspection device depicted in Fig. 5, a wafer 1 is loaded onto a wafer tray 13, wherein the wafer 1 along its back side 1$b$, on the reverse side from the front side where semiconductor films are layered, is fixed into place, with an O-ring 12 interposing, by a chuck stage 11. Since the back side 1$b$ is not specular, but has considerable surface roughness, the O-ring 12 is employed in order to form a complete seal between the wafer 1 and chuck stage 11.

The inspection device represented in Fig. 5 is utilized as follows to check whether pinholes are present. Namely, a not-illustrated negative-pressure source such as vacuum pump is operated to exhaust, as the arrow 14 indicates, and reduce the pressure of the interspace formed by the chuck stage 11 and the wafer 1, to put it in a vacuum state. The pressure of the interspace is monitored by a not-illustrated pressure gauge. At that time, should a pinhole(s) be formed in the wafer 1, air will leak through the pinhole(s) from the wafer-tray 13 side, and therefore the pressure of the interspace will gradually become elevated. In this way the chuck stage 11 is contacted onto the wafer 1 and a vacuum is drawn, enabling the presence of pinholes in the wafer 1 to be determined according to the elapsed-time change in the vacuum level.

Alternatively, the leak-modeled inspection device represented in Fig. 6, for example, can be employed to determine whether pinholes are present. In the inspection device depicted in Fig. 6, a wafer 1 is fixed into place, with an O-ring 22 interposing, in a chamber 21. A detecting-gas supply unit 23 is provided alongside the front side 1$a$ of the wafer 1.

The inspection device represented in Fig. 6 is utilized as follows to check whether pinholes are present. Namely, a not-illustrated negative-pressure source such as vacuum pump is operated to reduce the pressure of the interspace formed by the chamber 21 and the wafer 1, to put it in a vacuum state. In this state, a detecting gas such as helium or alcohol, for example, is sprayed through the detecting-gas supply unit 23, directed toward the front side 1$a$ of the wafer 1. At that time, should a pinhole(s) be formed in the wafer 1, the detecting gas will leak through the pinhole(s) toward the back side of the wafer 1. Leaking detecting gas will flow as indicated by the arrow 24, and the detecting gas will be sensed by a gas detection device 25. In this way, the presence of a pinhole(s) in the wafer 1 can be determined according to whether there is detection of the detecting gas.

As another example, the inspection device sketched in Fig. 9, utilizing the chuck unit, represented in Fig. 7, in which a porous plate is adopted, can be employed to determine whether pinholes are present. With the device configurations illustrated in Fig. 5 and Fig. 6, an interspace is formed in between the chuck stage 11 and the back side 1$b$ of the wafer 1, or in between the chamber 21 and the wafer 1. The wafer 1 is supported in the vicinity of the outer periphery by the O-ring 12, 22. This means that the wafer 1 central portion and its vicinity face onto the empty interspace, without being supported by any other components. With such configurations, when the vacuum pump is running to bring the interspace interior into a vacuum state, the wafer 1 bends in such a way that the wafer 1 central portion and its vicinity bulge toward the interspace, enlarging the amount of warpage in the wafer 1.

With the adhesion-modeled inspection device depicted in Fig. 5 and the leak-modeled inspection device depicted in Fig. 6, although the inspection accuracy improves the smaller the pressure inside the interspace is, the amount of warpage increases. Warping of the wafer 1 risks destruction of the wafer 1. Especially in instances in which pinholes have appeared in a wafer 1, when the wafer 1 is bent, a concentration of stress in the pinhole appearance sites occurs, augmenting the likelihood that the wafer 1 will break.

Under the circumstances, the chuck unit 40, as the chuck stage onto which the wafer 1 is adhered, can be configured as illustrated in Fig. 7. As shown in Fig. 7, the chuck unit 40 is furnished with a porous plate 41, a gel pad 42, and pedestal 43. A recess 43*a* is formed in the front side of the pedestal 43, with the porous plate 41 snugly fit into the interior of the recess 43*a*, being made unitary therewith. The gel pad 42 is glued to a pedestal 43 surface that the recess 43*a* defines. The gel pad 42 is glued to the peripheral margin of the recess 43*a*.

The wafer 1 is loaded onto the chuck unit 40 so as to be in full contact with both the porous plate 41 and the gel pad 42. The porous plate 41 is formed so that with respect to the wafer 1, its diameter will be slightly small, wherein the central portion of the wafer 1 is in full contact with the porous plate 41, and the peripheral portion of the wafer 1 is in full contact with the gel pad 42. When the wafer 1 is loaded and adhered onto the chuck unit 40, the gel pad 42 is compressed through the wafer 1 and is deformed. This deformation absorbs shock and averts damage to the back side 1*b* of the wafer 1, and at the same time brings the wafer 1 into intimate contact with both the porous plate 41 and the gel pad 42. With the wafer 1 loaded onto the chuck unit 40, nearly the entire back side 1*b* is in full contact with the porous plate 41, wherein save for a peripheral margin, over nearly the entire surface along its central portion the wafer 1 is supported by the porous plate 41.

It is necessary that the porous plate 41 have a high porosity-that its interior be breathable-and that the porous plate 41 be formed so as to let a wafer 1 loaded onto the porous plate 41 be vacuum-chucked. Furthermore, it is desirable that the porous plate 41 not scratch the wafer 1 by coming into contact with it, that it not be too fragile, and that its impurity content be a trace amount. For those purposes, employing a ceramic material such as alumina or silicon carbide as the porous plate 41 substance, the porous plate 41 can, for example, be formed by a low bulk-density (e.g., between 30% and 60% porosity) ceramic molded article. Specifically, a porous chuck onto which the entire surface of the wafer 1 can be adhesively fixed by negative pressure can be suitably employed as the porous plate 41.

The gel pad 42, furthermore, must be capable of tight contact with the wafer 1, and the gel pad 42 must be gas-impermeable. For those purposes, a synthetic resin material such as a soft silicone gel can, for example, be used as the gel pad 42 substance. Specifically, αGEL (registered trademark), which is a very soft gel-like base substance, can be ideally employed for the gel pad 42.

Furthermore, the pedestal 43 can be formed from a ceramic material of the same stock as that of the porous plate 41. The pedestal 43 must retain the porous plate 41, and with respect to the porous plate 41, the pedestal 43 must be of higher strength. Therefore, it is desirable that the pedestal 43 be formed so that with respect to the porous plate 41, it is of greater bulk density and lower porosity.

As indicated in Fig. 7, a ventilation channel 44 is formed in the bottom part of the recess 43*a* formed in the pedestal 43. And in the interior of the pedestal 43, a ventilation duct 45 communicating the ventilation channel 44 with the exterior of the pedestal 43 is formed. The ventilation duct 45 communicates the interior of the recess 43*a* with the interior of an exhaust tube 46 connected to a side portion of the pedestal 43. Exhaustion through the interior of the exhaust tube 46 as indicated by the arrow 47 reduces the pressure inside the ventilation duct 45, inside the ventilation channel 44, and inside the voids in the porous plate 41, whereby the wafer 1 loaded on porous plate 41 is vacuum-chucked, bringing the wafer 1 into tight contact with the porous plate 41.

In order that the wafer 1 along its peripheral margin and the gel pad 42 be in tight contact, the diameter *D* of the porous plate 41 as represented in Fig. 8 is defined to be smaller than the diameter of the wafer 1. When the diameter of the wafer 1 is 2 inches (50 mm), the porous plate 41 can be formed so that the diameter *D* is 47 mm.

Meanwhile, the thickness *t* of the porous plate 41 is designed to be of an extent that can secure strength in the porous plate 41, and also may be set at a dimension that facilitates manufacture of the porous plate 41. For example, the porous plate 41 thickness *t* can be designed to be one-tenth or more of the diameter *D*; when the diameter *D* is 47 mm, the porous plate 41 can be formed with the thickness *t* being 5 mm.

In addition, the full-contact surface 41*a*, represented in Fig. 8, which is the surface of the porous plate 41 on the side where it makes tight contact with the wafer 1, desirably is formed as a flat, smooth surface so that when the wafer 1 is vacuum-chucked, the full-contact surface 41*a* globally is in tight contact with the wafer 1, to minimize deformation of the wafer 1. In the instance for example in which the diameter *D* is 47 mm, the porous plate 41 can be formed so that the flatness tolerance of the full-contact surface 41*a* will be 0.01 mm.

In Fig. 9 a schematic extending from the chuck unit 40 to a vacuum pump 110 is presented, for an instance in which the chuck unit 40 has been adopted in an inspection device for determining whether pinholes are present. The exhaust tube 46 illustrated in Fig. 7 is connected to a coupling 101 along one end of a pneumatic line 100. The vacuum pump 110, as a negative-pressure source for reducing the pressure inside the chuck unit 40 to chuck the wafer 1, is connected to a coupling 102 along the other end of the pneumatic line 100. A vacuum line filter 103 is disposed in the pneumatic line 100 in the vicinity of the coupling 101, for removing foreign matter flowing into the pneumatic line 100 from the exhaust tube 46.

A pressure-gauge gate 105 is formed in the pneumatic line 100. A pressure gauge 120, which communicates with the pneumatic line 100 interior by means of a connecting tube 121 connected to the pressure-gauge gate 105, detects the pressure of the pneumatic line 100 interior. The pressure gauge 120 is fitted out with a pressure indicator 124 for displaying the detected pressure within the pneumatic line 100, an "OK" lamp 122 that lights when the pressure inside the pneumatic line 100 is within a prescribed range, and an "NG" lamp 123 that lights when the pressure inside the pneumatic line 100 is outside the prescribed range.

A cutoff valve 104 is disposed in between the pressure-gauge gate 105 and the coupling 102 connected to the vacuum pump 110. Operating the vacuum pump 110 when the cutoff valve 104 is in its open state vacuum-adheres the wafer 1 to the chuck unit 40. At that time, by adjusting the degree to which a manual valve 106 is open, the vacuum-adhesive force on the wafer 1 can be adjusted. Furthermore, by putting the cutoff valve 104 into its closed state, the system extending from the chuck unit 40 to the pressure gauge 120 is isolated from the vacuum pump 110, and the vacuum inside the pneumatic line 100 is maintained. Thus, the configuration is rendered one in which, when the cutoff valve 104 is closed, even if the vacuum pump 110 is operated, the pressure inside the pneumatic line 100 to the coupling 101 side of the cutoff valve 104 does not change.

A nitrogen purge line 130 is also connected to the pneumatic line 100. After inspection of a wafer 1 is finished, opening a cutoff valve 133 with the cutoff valve 104 in its closed state, and passing nitrogen through a gate 131 to the nitrogen purge line 130 and sending it into the pneumatic line 100 through the nitrogen purge line 130 puts the pneumatic line 100 and the interior of the exhaust tube 46 at normal atmospheric pressure or slightly positive pressure, easing removal of the wafer 1 from the chuck unit 40. When the pressure within the nitrogen purge line 130 goes over a prescribed value-in cases such as when nitrogen is injected through the gate 131 with the cutoff valve 133 left closed-a spring safety valve 132 opens, bleeding the nitrogen purge line 130, and thereby keeping the pressure within the nitrogen purge line 130 from becoming excessive.

The inspection device represented in Figs. 7 to 9 is employed to in the following way to examine whether pinholes are present. Namely, the vacuum pump 110, as a negative-pressure source, is operated to pump down and put into a vacuum state the pneumatic line 100, the exhaust tube 46, the ventilation duct 45, the ventilation channel 44, and the interior of the porous plate 41. Therein, the wafer 1 makes tight contact with the porous plate 41 and the gel pad 42. The pressure within the pneumatic line 100 in the vacuum state is monitored by the pressure gauge 120. In this state, with the cutoff valve 104 shut, the vacuum state is maintained and the pressure regimen within the pneumatic line 100 is monitored by the pressure gauge 120.

Accordingly, when a pinhole(s) appears in a wafer 1, because air will leak through the pinhole from the wafer front side 1*a* to the back side 1*b*, the pressure within the pneumatic line 100, monitored by the pressure gauge 120, will gradually rise. In this way, whether a pinhole(s) is present in the wafer 1 can be determined according to the elapsed-time change in the vacuum level with the wafer 1 having been vacuum-chucked to the chuck unit 40 adopting the porous plate 41.

As stated earlier, with the adhesion-modeled, represented in Fig. 5, and leak-modeled, represented in Fig. 6, inspection devices, when the pressure within the interspace formed in between the chuck stage 11 (or else the chamber 21) and the wafer 1 goes low, the amount of warpage in the wafer 1 increases, which runs the risk that the wafer 1 will break. In contrast, with the inspection device illustrated in Figs. 7 to 9, because the porous plate 41 is set up to hold the wafer 1, deflection of the wafer 1 while chucked is to a great extent minimized. Consequently, the vacuum pump 110 can be operated to bring the voids inside the porous plate 41 nearer to a vacuum state (that is, a low-pressure state).

In other words, the difference in pressure alongside the back side 1*b* and alongside the front side 1*a* of the wafer 1 in full contact with the porous plate 41 can be made greater by comparison with adhesion-modeled or leak-modeled inspection devices. This means that in wafer 1 instances in which a pinhole(s) appear, air passes through more readily from alongside the front side 1*a* to alongside the back side 1*b* via the pinhole(s). Accordingly, an inspection device of dramatically improved inspection accuracy-enabling the determination as to whether pinhole(s) are present in a wafer 1 to be made with better precision, and enabling more minute pinholes to be detected-can be made available.

It should be noted that in addition to the scheme illustrated in Fig. 9, a gas detection device 25 (cf. Fig. 6) may be installed, the gas detection device 25 may be connected into the pneumatic line 100 to the coupling 101 side of the cutoff valve 104, and a detecting-gas supply unit 23 (cf. Fig. 6) may be disposed in the vicinity of the front side 1*a* of the wafer 1. In that case, whether pinhole(s) are present in the wafer 1 can be determined by spraying detecting gas from the detecting-gas supply unit 23 directed toward the front side 1*a* of the wafer 1 and sensing, by means of the gas detection device 25, detecting gas having leaked along the back side 1*b* of the wafer 1 through a pinhole(s).

Returning to Fig. 4: Next, in Step S3 wafers determined in Step S2 to have a pinhole(s) present are identified. For wafers identified as having a pinhole(s), next, in Step S4, the number and position of the pinholes is characterized. To characterize the number and position of pinholes, the inspection device represented in Fig. 10, modeled on a probe-beam light source, can for example be employed.

With the inspection device represented in Fig. 10, a light source 31 is set up along the back side of a wafer 1. A beam 32 is emitted from the light source 31. Therein, in the manner of arrow 34, light transiting a pinhole in the wafer 1 leaks to the front side of the wafer 1. Detecting rays passing through the wafer 1 makes it possible to characterize the number and position of the pinholes. The characterized pinhole positions can be recorded by, for example, imaging and storing, in a format such as JPEG, the light rays having leaked through, and placing indicia on the image.

Moreover, even if the wafer 1 is of material that transmits visible light, such as GaN for example, by adjusting the wavelength and emission intensity of the light beam 32 emitted from the light source 31 to make the light transmitted through to the front side of the wafer 1 graphically recognizable and carry out an imaging process, the number and position of pinholes can be characterized. As to the wavelength of the light 32, selecting a wavelength that will not pass through the wafer 1-for example, if GaN, then a wavelength of 365 nm or less-is preferable because then rays transiting the pinhole(s) and leaking along the back side of the wafer 1 can be sensed. Alternatively, a wafer 1 having pinholes may be prepared, and while the emission intensity is varied, the emission intensity may be adjusted so that the contrast will be at its most distinct, following which the probe may be implemented.

In this way, wafers with pinholes-whose pinhole count and position has been characterized in Step S4-and wafers determined in Step S2 not to have pinholes are next, in Step S5, discriminated as to whether they are qualifying products. For example, a standard can be established according to which the number of pinholes per substrate for diameter 2-inch wafers being from one to twenty is a qualifying product, while pinholes being nil or twenty-one or more is a non-qualifying product. Further, when gathering of data on the pinhole diameter is carried out by means of the imaging process in Step S4, in addition to the just-described standard based on pinhole count, a standard can be established according to which instances of the pinhole diameter being between 0.45 $\mu$m and 5 $\mu$m are qualifying products, to implement qualifying-product identification. It will be appreciated that a light microscope or laser microscope, or else a scanning electron microscope (SEM), for example, can be employed to determine the pinhole diameter.

As in the foregoing, with semiconductor wafer inspection method of the invention, after the determination, in Step S2, as to the presence of pinholes in wafers is made, the examination, in Step S4, to specify the number and position of pinholes is carried out on only those wafers determined to have pinholes. An examination for specifying the number and position of pinholes in respect of the total number of wafers is not implemented. That is, wafers in which it is determined that pinholes do not exist are excluded from the examination, in Step S3, for specifying the number and position of pinholes. Consequently, the presence of pinholes in wafers, and when pinholes are present, their position and number, can be efficiently examined.

The presently disclosed embodying modes should in all respects be considered to be illustrative and not limiting. The scope of the present invention is set forth not by the foregoing description but by the scope of the patent claims, and is intended to include meanings equivalent to the scope of the patent claims and all modifications within the scope.

## Claims

1. A semiconductor wafer in which between one and twenty pinholes are formed per two inches diameter.

2. A semiconductor wafer as set forth in claim 1, wherein the diameter of the pinholes is between 0.45 $\mu$m and 5 $\mu$m.

3. A semiconductor wafer inspection method provided with:

   a step of contacting a chuck stage onto the front side of a wafer to vacuum chuck it, and determining whether pinholes are present in the wafer by either change in the vacuum level with elapsed time, or by whether there is detection of a detecting gas; and
   a step of directing a beam of light onto the front side of a wafer determined to have pinholes, detecting light rays passing through the wafer, and thereby specifying the number and position of the pinholes.

FIG. 1

FIG. 2

FIG. 3

FIG. 4

```
        ┌──────────────┐
        │    START     │
        └──────┬───────┘
               │          ⌐ S1
        ┌──────┴───────┐
        │ Prepare wafer │
        └──────┬───────┘
               │          ⌐ S2
        ┌──────┴───────┐
        │ Determine whether │
        │ there are pinholes │
        └──────┬───────┘
               │          ⌐ S3
            ◇───────────◇
            │ Pinholes present │  NO
            ◇───────────◇────────┐
               │ YES              │
               │          ⌐ S4    │
        ┌──────┴───────┐          │
        │ Characterize pinhole │   │
        │ count and position │    │
        └──────┬───────┘          │
               │◄─────────────────┘
               │          ⌐ S5
        ┌──────┴───────┐
        │ Identify qualifying │
        │   products    │
        └──────┬───────┘
        ┌──────┴───────┐
        │     END      │
        └──────────────┘
```

FIG. 5

FIG. 6

FIG. 7

FIG. 8

FIG. 9

FIG. 10

## INTERNATIONAL SEARCH REPORT

| | International application No. |
|---|---|
| | PCT/JP2008/068012 |

A.   CLASSIFICATION OF SUBJECT MATTER
*H01L21/66*(2006.01)i

According to International Patent Classification (IPC) or to both national classification and IPC

B.   FIELDS SEARCHED

Minimum documentation searched (classification system followed by classification symbols)
H01L21/66, G01M3/04

Documentation searched other than minimum documentation to the extent that such documents are included in the fields searched
Jitsuyo Shinan Koho        1922-1996   Jitsuyo Shinan Toroku Koho   1996-2008
Kokai Jitsuyo Shinan Koho   1971-2008   Toroku Jitsuyo Shinan Koho   1994-2008

Electronic data base consulted during the international search (name of data base and, where practicable, search terms used)

C.   DOCUMENTS CONSIDERED TO BE RELEVANT

| Category* | Citation of document, with indication, where appropriate, of the relevant passages | Relevant to claim No. |
|---|---|---|
| X<br>Y | WO 2002/099169 A1   (The New Industry Research Organization),<br>12 December, 2002 (12.12.02),<br>Claim 1; page 7, line 15 to page 8, line 23<br>& US 2004/0237879 A1     & EP 1403404 A1 | 1<br>2 |
| X<br>Y | JP 2007-269627 A  (Central Research Institute of Electric Power Industry),<br>18 October, 2007 (18.10.07),<br>Par. Nos. [0016], [0057]<br>& US 2005/0181627 A1     & EP 1491662 A1<br>& WO 2003/078702 A1     & CN 1643188 A | 1<br>2 |
| Y | JP 2005-311261 A  (Nippon Steel Corp.),<br>04 November, 2005 (04.11.05),<br>Par. No. [0012]<br>(Family: none) | 2 |

| ☒  Further documents are listed in the continuation of Box C. | ☐  See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 26 December, 2008 (26.12.08) | 13 January, 2009 (13.01.09) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

| International application No. |
| --- |
| PCT/JP2008/068012 |

C (Continuation).   DOCUMENTS CONSIDERED TO BE RELEVANT

| Category* | Citation of document, with indication, where appropriate, of the relevant passages | Relevant to claim No. |
| --- | --- | --- |
| Y | JP 2001-237286 A  (Kyoshin Electric Co., Ltd.), 31 August, 2001 (31.08.01), Claim 1; Par. Nos. [0011] to [0030] (Family: none) | 3 |
| Y | JP 2004-309426 A  (Denso Corp.), 04 November, 2004 (04.11.04), Par. Nos. [0038] to [0061]; Figs. 1 to 5 (Family: none) | 3 |
| A | JP 6-183879 A  (Ibiden Co., Ltd.), 05 July, 1994 (05.07.94), Par. No. [0020] (Family: none) | 1,2 |

Form PCT/ISA/210 (continuation of second sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 10509943 A